# EUROPEAN PATENT APPLICATION

(11) **EP 4 788 109 A1**
(43) Date of publication of application: **05.08.2026**
(21) Application number: 23954350.7
(22) Date of filing: 29.09.2023
(51) Int. Cl.: H10N 60/10, H10N 60/12, H10N 69/00

(54) **QUANTUM DEVICE**

(71) Applicant: FUJITSU LIMITED, Kawasaki-shi, Kanagawa 211-8588 (JP)
(72) Inventor: SAIDA, Daisuke, Kawasaki-shi, Kanagawa 211-8588 (JP); SHIBA, Shoichi, Kawasaki-shi, Kanagawa 211-8588 (JP)
(74) Representative: Haseltine Lake Kempner LLP
(86) International application number: PCT/JP2023/035657
(87) International publication number: WO 2025/069381

(57) **Abstract**

A quantum device includes a plurality of superconducting qubits, a plurality of resonators capacitively coupled to the plurality of superconducting qubits, respectively, a filter coupled to the plurality of resonators, and a port capacitively coupled to the filter, wherein shortest distances between the port and the plurality of resonators are equal among the plurality of resonators. The quantum device can be used for quantum computing, for example.

## Description

### TECHNICAL FIELD

The present disclosure relates to quantum devices.

### BACKGROUND ART

There is a proposed quantum device including a plurality of qubits coupled to a single readout port via resonators and filters.

### PRIOR ART DOCUMENTS

### PATENT DOCUMENTS

Patent Document 1: Japanese National Publication of International Patent Application No. 2018-533253
Patent Document 2: Japanese National Publication of International Patent Application No. 2019-530336
Patent Document 3: Japanese Laid-Open Patent Publication No. 2022-172189
Patent Document 4: U.S. Patent Application Publication No. 2016/0112031

### DISCLOSURE OF THE INVENTION

### PROBLEM TO BE SOLVED BY THE INVENTION

In the conventional quantum device, the parasitic capacitances are likely to differ among the plurality of resonators.

One object of the present disclosure is to provide a quantum device capable of suppressing variation in parasitic capacitance of resonators.

### MEANS OF SOLVING THE PROBLEM

According to an aspect of the present disclosure, a quantum device includes a plurality of superconducting qubits; a plurality of resonators capacitively coupled to the plurality of superconducting qubits, respectively; a filter coupled to the plurality of resonators; and a port capacitively coupled to the filter, wherein shortest distances between the port and the plurality of resonators are equal among the plurality of resonators.

### EFFECTS OF THE INVENTION

According to the present disclosed technique, it is possible to suppress variation in parasitic capacitance of resonators.

### BRIEF DESCRIPTION OF THE DRAWINGS

[FIG. 1] FIG. 1 is a plan view illustrating a quantum device according to a first embodiment.
[FIG. 2] FIG. 2 is a plan view illustrating a quantum device according to a reference example.
[FIG. 3] FIG. 3 is a diagram illustrating computation results of resonant frequencies.
[FIG. 4] FIG. 4 is a plan view illustrating the quantum device according to a second embodiment.
[FIG. 5] FIG. 5 is a plan view illustrating the quantum device according to a third embodiment.
[FIG. 6] FIG. 6 is a plan view illustrating the quantum device according to a fourth embodiment.
[FIG. 7] FIG. 7 is a plan view illustrating the quantum device according to a fifth embodiment.
[FIG. 8] FIG. 8 is a plan view illustrating the quantum device according to a sixth embodiment.
[FIG. 9] FIG. 9 is a plan view illustrating the quantum device according to a seventh embodiment.
[FIG. 10] FIG. 10 is a diagram illustrating a simulation result of the quantum device according to the reference example.
[FIG. 11] FIG. 11 is a diagram illustrating a simulation result of the quantum device according to the fourth embodiment.
[FIG. 12] FIG. 12 is a diagram illustrating a simulation result of the quantum device according to the sixth embodiment.

### MODE OF CARRYING OUT THE INVENTION

Hereinafter, embodiments of the present disclosure will be specifically described with reference to the accompanying drawings. In the present specification and drawings, constituent elements having substantially the same functional configuration are designated by the same reference numerals, and a redundant description thereof may be omitted. In the following description, an XYZ orthogonal coordinate system is used, but the coordinate system is defined for the sake of convenience of description, and does not limit the orientation of the quantum device. In addition, when viewed from an arbitrary point, a +Z side may be referred to as upward, upper side, or above, and a -Z side may be referred to as a downward, lower side, or below. In addition, a plan view of an object refers to a view of the object viewed from the +Z side, and a planar shape of the object refers to a shape of the object in the plan view viewed from the +Z side.

### (First Embodiment)

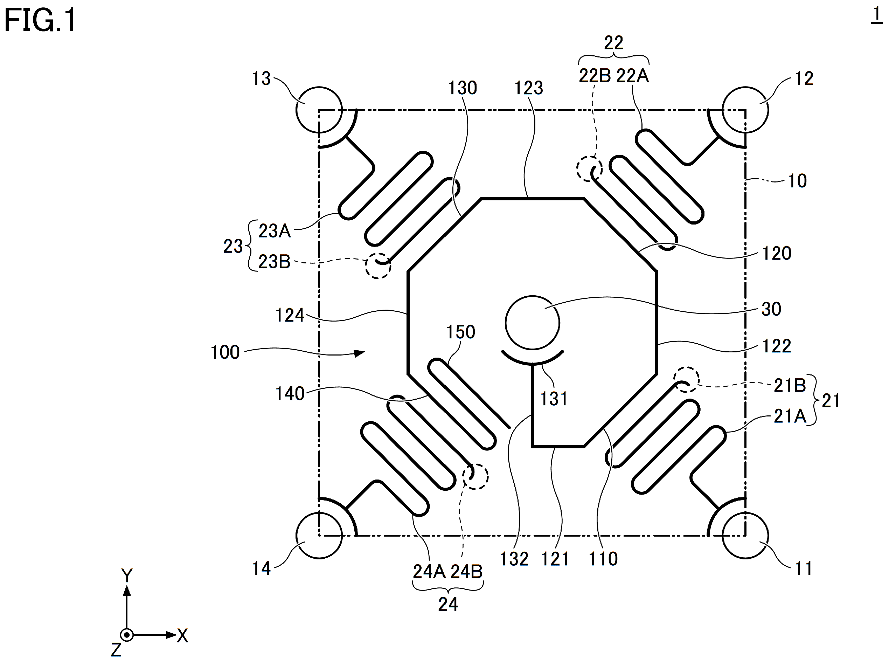

First, a first embodiment will be described. A first embodiment relates to a quantum device. FIG. 1 is a plan view illustrating the quantum device according to the first embodiment.

As illustrated in FIG. 1, a quantum device 1 according to the first embodiment includes qubits 11, 12, 13, and 14. The qubits 11 through 14 are superconducting qubits and include Josephson junctions, for example. The qubits 11 through 14 are located at the vertices of a square 10 in the plan view. X coordinates of the qubits 11 and 12 are the same, and X coordinates of the qubits 13 and 14 are the same. Y coordinates of the qubits 11 and 14 are the same, and Y coordinates of the qubits 12 and 13 are the same. The qubit 11 is located on the +X side of the qubit 14, and qubit 12 is located on the +X side of qubit 13. The qubit 12 is located on the +Y side of the qubit 11, and the qubit 13 is located on the +Y side of the qubit 14. The qubits 11 through 14 have resonant frequencies in a range of 3 GHz to 10 GHz, for example.

The quantum device 1 includes a readout port 30. The readout port 30 is located at a center of the square 10. The readout port 30 includes a circular metal film, for example.

The quantum device 1 includes resonators 21, 22, 23 and 24. The resonator 21 has a base 21A and a resonant frequency adjuster 21B connected to the base 21A. The resonator 22 has a base 22A and a resonant frequency adjuster 22B connected to the base 22A. The resonator 23 has a base 23A and a resonant frequency adjuster 23B connected to the base 23A. The resonator 24 has a base 24A and a resonant frequency adjuster 24B connected to the base 24A.

The shapes and sizes of the bases 21A, 22A, 23A, and 24A are the same. That is, the bases 21A, 22A, 23A, and 24A are congruent in the plan view. The bases 21A, 22A, 23A, and 24A include a transmission line having a meander geometry. The base 21A has a portion extending perpendicular to a line segment connecting the readout port 30 and the qubit 11. The base 22A has a portion extending perpendicular to a line segment connecting the readout port 30 and the qubit 12. The base 23A has a portion extending perpendicular to a line segment connecting the readout port 30 and the qubit 13. The base 24A has a portion extending perpendicular to a line segment connecting the readout port 30 and the qubit 14. The base 21A is capacitively coupled to the qubit 11. The base 22A is capacitively coupled to the qubit 12. The base 23A is capacitively coupled to the qubit 13. The base 24A is capacitively coupled to the qubit 14. The bases 21A, 22A, 23A, and 24A are arranged to have fourfold rotational symmetry about the readout port 30. Shortest distances between the readout port 30 and the bases 21A, 22A, 23A, and 24A are equal among the resonators 21 through 24.

The resonant frequency adjusters 21B, 22B, 23B, and 24B have transmission lines having slightly different path lengths. These transmission lines are short-circuited to a ground line. The resonators 21 through 24 have slightly different resonant frequencies. For example, the resonant frequency of the resonator 21 is 10.1 GHz, the resonant frequency of the resonator 22 is 10.2 GHz, the resonant frequency of the resonator 23 is 10.3 GHz, and the resonant frequency of the resonator 24 is 10.4 GHz. The resonant frequency adjusters 21B, 22B, 23B, and 24B are separated from portions of the bases 21A, 22A, 23A, and 24A closest to the readout port 30, respectively. Shortest distances between the readout port 30 and the resonators 21 through 24 are equal among the resonators 21 through 24.

The quantum device 1 includes a filter 100. The filter 100 is coupled to the resonators 21 through 24. For example, the filter 100 is capacitively coupled to the resonators 21 through 24. In addition, the readout port 30 is capacitively coupled to the filter 100. The filter 100 includes transmission lines 110, 120, 130, 140, 150, 121, 122, 123, 124, 131, and 132.

The transmission line 131 is provided near the readout port 30, and has a planar shape along an outer edge of the readout port 30. The planar shape of the transmission line 131 is an arc shape, for example. The transmission line 131 is located on the -Y side of the readout port 30. The transmission line 132 is connected to the transmission line 131, and extends from the transmission line 131 toward the -Y side along the Y axis.

The transmission line 121 is connected to the transmission line 132, and extends from an end portion of the transmission line 132 on the -Y side toward the +X side along the X axis. The transmission line 110 is connected to the transmission line 121, extends from an end portion of the transmission line 121 on the +X side toward the +X side and the +Y side perpendicularly to a line segment connecting the readout port 30 and the qubit 11, and intersects the line segment connecting the readout port 30 and the qubit 11. The transmission line 122 is connected to the transmission line 110, and extends from an end portion of the transmission line 110 on the +X side and the +Y side toward the +Y side along the Y axis. The transmission line 120 is connected to the transmission line 122, extends from an end portion of the transmission line 122 on the +Y side toward the -X side and the +Y side perpendicularly to a line segment connecting the readout port 30 and the qubit 12, and intersects the line segment connecting the readout port 30 and the qubit 12. The transmission line 123 is connected to the transmission line 120, and extends from an end portion of the transmission line 120 on the -X side and the +Y side toward the -X side along the X axis. The transmission line 130 is connected to the transmission line 123, extends from an end portion of the transmission line 123 on the -X side toward the -X side and the -Y side perpendicularly to a line segment connecting the readout port 30 and the qubit 13, and intersects the line segment connecting the readout port 30 and the qubit 13. The transmission line 124 is connected to the transmission line 130, and extends from an end portion of the transmission line 130 on the -X side and the -Y side toward the -Y side along the Y axis. The transmission line 140 is connected to the transmission line 124, extends from an end portion of the transmission line 124 on the -Y side toward the +X side and the -Y side perpendicularly to a line segment connecting the readout port 30 and the qubit 14, and intersects the line segment connecting the readout port 30 and the qubit 14. The transmission line 150 is connected to the transmission line 140, and has a meander geometry that meanders from an end portion of the transmission line 140 on the +X side and the -Y side toward the readout port 30.

A path length of the filter 100 may be on the order of one wavelength λ. For example, at the resonant frequency of 6 GHz of the qubit, the path length is approximately 1/2 the wavelength λ in order to prevent propagation of photons emitted from the qubit. On the other hand, this filter does not prevent propagation of a signal having a frequency of 10 GHz at which the resonators 21 through 24 resonate, for example. In a case where the path length of the filter 100 is approximately one wavelength λ or approximately 1/2 the wavelength λ, an end of the filter 100 on the side opposite from the readout port 30 is open-circuited.

The transmission lines 110, 120, 130, and 140 are arranged to have fourfold rotational symmetry about the readout port 30. Shortest distances between the readout port 30 and the transmission lines 110, 120, 130 and 140 are equal. In addition, a shortest distance between the transmission line 110 and the base 21A, a shortest distance between the transmission line 120 and the base 22A, a shortest distance between the transmission line 130 and the base 23A, and a shortest between the transmission line 140 and the base 24A are equal.

In the quantum device 1, states of the qubits 11 through 14 can be read out simultaneously by inputting a signal of 10 GHz to the readout port 30. That is, because the resonant frequencies of the resonators 21 through 24 differ, the states of the qubits 11 through 14 can be read out simultaneously by frequency-separating the read signal.

Moreover, the shortest distances between the readout port 30 and the resonators 21 through 24 are equal among the resonators 21 through 24. For this reason, differences in parasitic capacitance among the resonators 21 through 24 can be made small. In a case where the difference in parasitic capacitance is large, the resonant frequencies of the resonators 21 through 24 may easily deviate from design values. In addition, an amount of shift in the resonant frequency may differ among the resonators 21 through 24, and frequency separation may be difficult. According to the present embodiment, these problems can be reduced.

Further, the resonators 21 through 24 include a superconducting thin film, for example, and even in a case where a thickness variation of the superconducting thin film occurs, uniformity of the thickness variation can be improved because of the shortest distances that are equal among the resonators 21 through 24. Accordingly, even in a case where uniformity of the amount of shift of the resonant frequency due to the thickness variation is high and the thickness variation of the superconducting thin film occurs, the frequency separation can be reliably performed.

In addition, via holes may be formed in the quantum device 1 for suppressing chip modes, spurious modes, or the like. The via holes may be formed before the resonators 21 through 24, or may be formed after the resonators 21 through 24. In a case where the via holes are formed before the resonators 21 through 24, a thickness of a resist used for forming the resonators 21 through 24 may be affected by the via holes. However, when the shortest distances are equal among the resonators 21 through 24, a high thickness uniformity of the resist is likely obtained around areas where the resonators 21 through 24 are to be formed. In addition, in a case where the via holes are formed after the resonators 21 through 24, the thickness of the resist used for forming the via holes and interference during exposure may be affected by the resonators 21 through 24. However, when the shortest distances are equal among the resonators 21 through 24, a high thickness uniformity of the resist is likely obtained around the regions where the resonators 21 through 24 are to be formed and a high uniformity is likely obtained in the interference during the exposure.

The filter 100 may be magnetically coupled to the resonators 21 through 24.

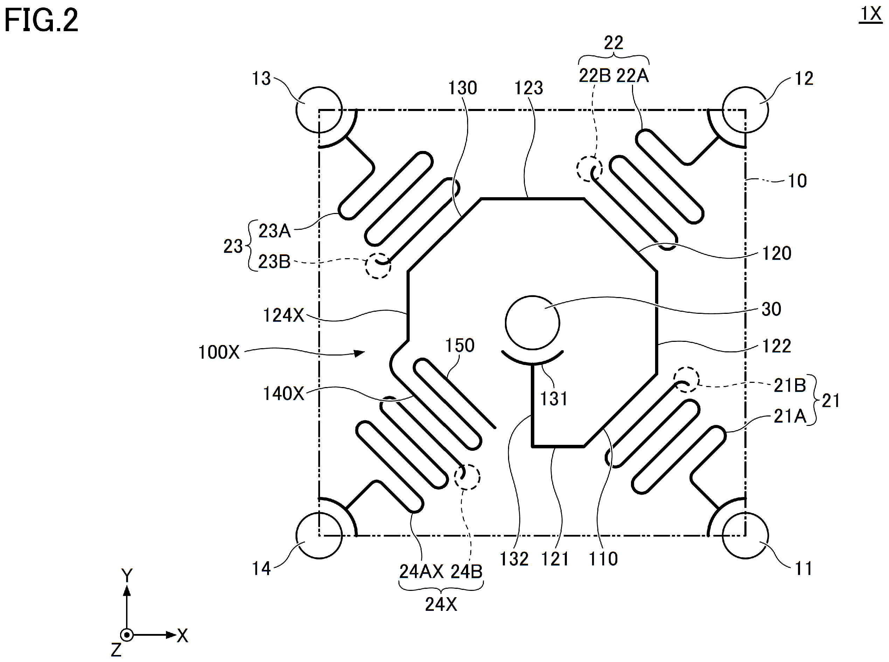

Next, effects of the first embodiment will be further described in comparison with a reference example. FIG. 2 is a plan view illustrating a quantum device according to the reference example.

As illustrated in FIG. 2, a quantum device 1X according to the reference example includes a filter 100X in place of the filter 100, and a resonator 24X in place of the resonator 24. Otherwise, the configuration of the quantum device 1X is the same as that of the quantum device 1.

The filter 100X includes a transmission line 124X in place of the transmission line 124, and a transmission line 140X in place of the transmission line 140. Otherwise, the configuration of the filter 100X is the same as that of the filter 100. The transmission line 124X is shorter than the transmission line 124. The transmission line 140X extends slightly from an end portion of the transmission line 124X on the -Y side toward the -X side and the -Y side, and extends from there to the +X side and the -Y side perpendicularly to the line segment connecting the readout port 30 and the qubit 14, and intersects the line segment connecting the readout port 30 and the qubit 14, similar to the transmission line 140. The transmission line 150 is connected to the transmission line 140X, and has a meander geometry that meanders from an end portion of the transmission line 140X on the +X side and the -Y side toward the readout port 30.

In the quantum device 1X, a shortest distance between the readout port 30 and the transmission line 140X is longer than the shortest distances between the readout port 30 and the transmission lines 110, 120, and 130, respectively. In addition, the shortest distance between the readout port 30 and the transmission line 150 is equal to the shortest distances between the readout port 30 and the transmission lines 110, 120, and 130, respectively.

The resonator 24X includes a base 24AX, and a resonant frequency adjuster 24B connected to the base 24A. The base 24AX includes a transmission line having a meander geometry with a shorter period than the base 24A. A shortest distance between the readout port 30 and the resonator 24X is longer than the shortest distances between the readout port 30 and the resonators 21, 22 and 23, respectively. Otherwise, the configuration of the resonator 24X is the same as that of the resonator 24.

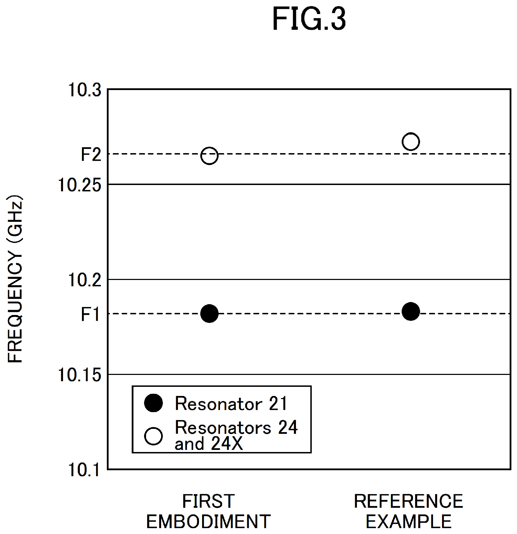

The present inventors computed the resonant frequencies by simulation for cases where the quantum devices according to the first embodiment and the reference example are manufactured. In the first embodiment, the resonant frequencies of the resonators 21 and 24 were computed, and in the reference example, the resonant frequencies of the resonators 21 and 24X were computed. In this example, a designed resonant frequency F1 of the resonator 21 was set to 10.18 GHz, and the resonant frequency of the resonators 24 and 24X was set to 10.27 GHz. The computation results of the resonant frequencies are illustrated in FIG. 3.

FIG. 3 is a diagram illustrating computation results of the resonant frequencies. As illustrated in FIG. 3, in the manufactured quantum device according to the first embodiment, the resonant frequencies of the resonators 21 and 24 substantially matched the design values. On the other hand, in the manufactured quantum device according to the reference example, the resonant frequencies of the resonator 21 and 24X were higher than the designed values.

From these results, it is found that the first embodiment can provide the effect of suppressing variation in the resonant frequency.

### (Second Embodiment)

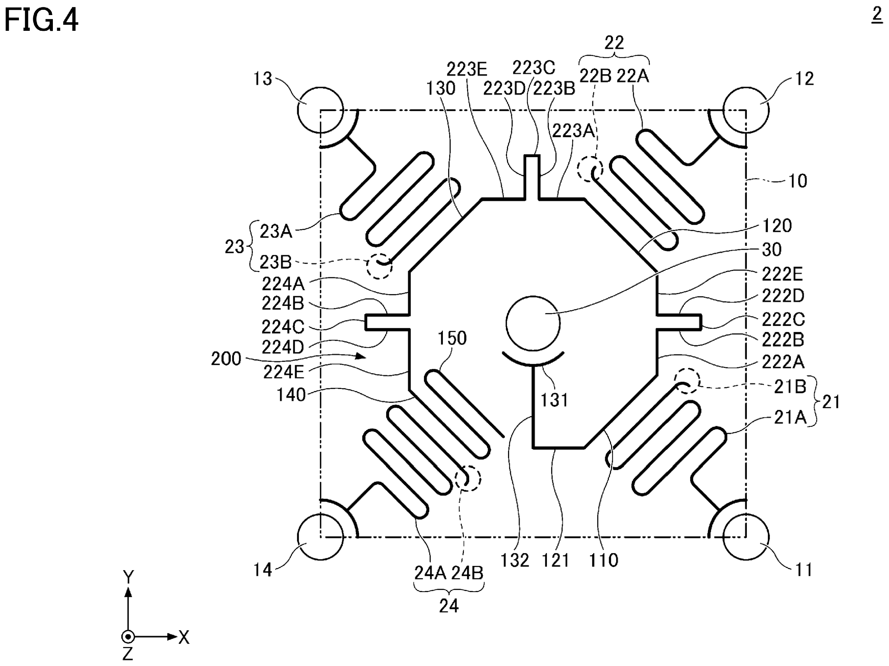

Next, a second embodiment will be described. The second embodiment differs from the first embodiment mainly in the configuration of the filter. FIG. 4 is a plan view illustrating the quantum device according to the second embodiment.

As illustrated in FIG. 4, a quantum device 2 according to the second embodiment includes a filter 200 in place of the filter 100. The filter 200 includes transmission lines 222A, 222B, 222C, 222D, and 222E in place of the transmission line 122, transmission lines 223A, 223B, 223C, 223D, and 223E in place of the transmission line 123, and transmission lines 224A, 224B, 224C, 224D, and 224E in place of the transmission line 124.

The transmission line 222A is connected to the transmission line 110, and extends from the end portion of the transmission line 110 on the +X side and the +Y side toward the +Y side along the Y axis. The transmission line 222B is connected to the transmission line 222A, and extends from an end portion of the transmission line 222A on the +Y-side toward the +X side along the X axis. The transmission line 222C is connected to the transmission line 222B, and extends from an end portion of the transmission line 222B on the +X side toward the +Y side along the Y axis. The transmission line 222D is connected to the transmission line 222C, and extends from an end portion of the transmission line 222C on the +Y side toward the -X side along the X axis. The transmission line 222E is connected to the transmission lines 222D and 120, and extends from an end portion of the transmission line 222D on the -X side toward the +Y side along the Y axis. The transmission lines 222A and 222E are arranged in line symmetry with respect to a straight line passing through the center of the square 10 and parallel to the X axis, and the transmission lines 222B and 222D are arranged in line symmetry with respect to the straight line passing through the center of the square 10 and parallel to the X axis.

The transmission line 223A is connected to the transmission line 120, and extends from the end portion of the transmission line 120 on the -X side and the +Y side toward the -X side along the X axis. The transmission line 223B is connected to the transmission line 223A, and extends from an end portion of the transmission line 223A on the -X side toward the +Y side along the Y axis. The transmission line 223C is connected to the transmission line 223B, and extends from an end portion of the transmission line 223B on the +Y side toward the -X side along the X axis. The transmission line 223D is connected to the transmission line 223C, and extends from an end portion of the transmission line 223C on the -X side toward the -Y side along the Y axis. The transmission line 223E is connected to the transmission lines 223D and 130, and extends from an end portion of the transmission line 223D on the -Y side toward the -X side along the X axis. The transmission lines 223A and 223E are arranged in line symmetry with respect to a straight line passing through the center of the square 10 and parallel to the Y axis, and the transmission lines 223B and 223D are arranged in line symmetry with respect to the straight line passing through the center of the square 10 and parallel to the Y axis.

The transmission line 224A is connected to the transmission line 130, and extends from the end portion of the transmission line 130 on the -X side and the -Y side toward the -Y side along the Y axis. The transmission line 224B is connected to the transmission line 224A, and extends from an end portion of the transmission line 224A on the -Y side toward the -X side along the X axis. The transmission line 224C is connected to the transmission line 224B, and extends from an end portion of the transmission line 224B on the -X side toward the -Y side along the Y axis. The transmission line 224D is connected to the transmission line 224C, and extends from an end portion of the transmission line 224C on the -Y side toward the +X side along the X axis. The transmission line 224E is connected to the transmission lines 224D and 140, and extends from an end portion of the transmission line 224D on the +X side toward the -Y side along the Y axis. The transmission lines 224A and 224E are arranged in line symmetry with respect to the straight line passing through the center of the square 10 and parallel to the X axis, and the transmission lines 224B and 224D are arranged in line symmetry with respect to the straight line passing through the center of the square 10 and parallel to the X axis.

A path length of the filter 200 may be approximately 1/2 the wavelength λ or approximately one wavelength λ. For example, in a case where the resonant frequency of the qubit is 6 GHz, the path length is approximately 1/2 the wavelength λ or approximately one wavelength λ in order to prevent the propagation of photons emitted from the qubit. On the other hand, this filter does not prevent the propagation of the signal having the frequency of 10 GHz at which the resonators 21 through 24 resonate, for example. In addition, the filter 200 may be magnetically coupled to the resonators 21 through 24.

Otherwise, the configuration of the quantum device 2 is the same as that of the quantum device 1. The quantum device 2 according to the second embodiment can also provide the same effects as those of the first embodiment.

### (Third Embodiment)

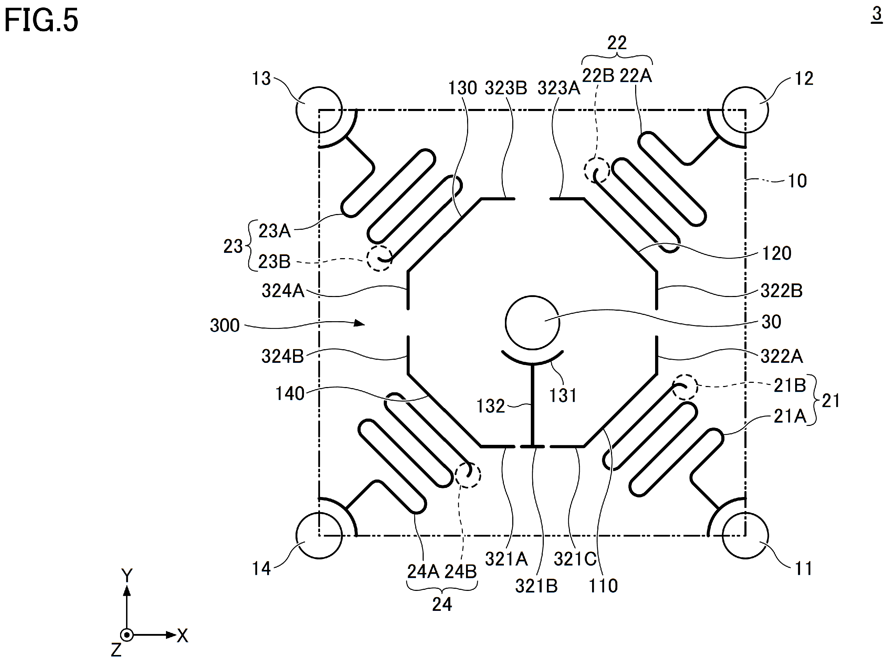

Next, a third embodiment will be described. The third embodiment differs from the first embodiment mainly in the configuration of the filter. FIG. 5 is a plan view illustrating the quantum device according to the third embodiment.

As illustrated in FIG. 5, a quantum device 3 according to the third embodiment includes a filter 300 in place of the filter 100. The filter 300 includes transmission lines 321A, 321B, and 321C in place of the transmission line 121, transmission lines 322A and 322B in place of the transmission line 122, transmission lines 323A and 323B and in place of the transmission line 123, and transmission lines 324A and 324B in place of the transmission line 124.

The transmission line 321B is connected to the transmission line 132, and extends from the end portion of the transmission line 132 on the -Y side toward the +X side and the -X side along the X axis. The transmission line 321A is connected to the transmission line 140, and extends from the end portion of the transmission line 140 on the +X side and the -Y side toward the +X side along the X axis. The transmission line 321C is connected to the transmission line 110, and extends from the end portion of the transmission line 110 on the -X side and the -Y side toward the -X side along the X axis. The transmission line 321A and the transmission line 321C are separated from the transmission line 321B. The Y coordinates of the transmission lines 321A, 321B and 321C are identical. The transmission line 321A and the transmission line 321B are capacitively coupled to each other, and the transmission line 321C and the transmission line 321B are capacitively coupled to each other. An end portion of the transmission line 321A on the +X side, an end portion of the transmission line 321B on the -X side, an end portion of the transmission line 321B on the +X side, and an end portion of the transmission line 321C on the -X side are open-circuited. The transmission lines 321A and 321C are arranged in line symmetry with respect to a straight line passing through the center of the square 10 and parallel to the Y axis.

The transmission line 322A is connected to the transmission line 110, and extends from the end portion of the transmission line 110 on the +X side and the +Y side toward the +Y side along the Y axis. The transmission line 322B is connected to the transmission line 120, and extends from the end portion of the transmission line 120 on the +X side and the -Y side toward the -Y side along the Y axis. The X coordinates of the transmission lines 322A and 322B are identical. The transmission line 322A and the transmission line 322B are capacitively coupled to each other. An end portion of the transmission line 322A on the +Y side and an end portion of the transmission line 322B on the -Y side are open-circuited. The transmission lines 322A and 322B are arranged in line symmetry with respect to a straight line passing through the center of the square 10 and parallel to the X axis.

The transmission line 323A is connected to the transmission line 120, and extends from the end portion of the transmission line 120 on the -X side and the +Y side toward the -X side along the X axis. The transmission line 323B is connected to the transmission line 130, and extends from the end portion of the transmission line 130 on the +X side and the +Y side toward the +X side along the X axis. The Y coordinates of the transmission lines 323A and 323B are identical. The transmission line 323A and the transmission line 323B are capacitively coupled to each other. An end portion of the transmission line 323A on the -X side and an end portion of the transmission line 323B on the +X side are open-circuited. The transmission lines 323A and 323B are arranged in line symmetry with respect to the straight line passing through the center of the square 10 and parallel to the Y axis.

The transmission line 324A is connected to the transmission line 130, and extends from the end portion of the transmission line 130 on the -X side and the -Y side toward the -Y side along the Y axis. The transmission line 324B is connected to the transmission line 140, and extends from the end portion of the transmission line 140 on the -X side and the +Y side toward the +Y side along the Y axis. The X coordinates of the transmission lines 324A and 324B are identical. The transmission line 324A and the transmission line 324B are capacitively coupled to each other. An end portion of the transmission line 324A on the -Y side and an end portion of the transmission line 324B on the +Y side are open-circuited. The transmission lines 324A and 324B are arranged in line symmetry with respect to the straight line passing through the center of the square 10 and parallel to the X axis.

A path length of the filter 300 may be approximately 1/2 the wavelength λ or approximately one wavelength λ. For example, in a case where the resonant frequency of the qubit is 6 GHz, the path length is approximately 1/2 the wavelength λ or approximately one wavelength λ in order to prevent the propagation of photons emitted from the qubit. On the other hand, this filter does not prevent the propagation of the signal having the frequency of 10 GHz at which the resonators 21 through 24 resonate, for example. In addition, the filter 300 may be magnetically coupled to the resonators 21 through 24.

Otherwise, the configuration of the quantum device 3 is the same as that of the quantum device 1. The quantum device 3 according to the third embodiment can also provide the same effects as those of the first embodiment.

Moreover, in the quantum device 3, because the filter 300 includes a plurality of transmission lines capacitively coupled to one another, it is possible to improve isolation and reduce spurious modes.

### (Fourth Embodiment)

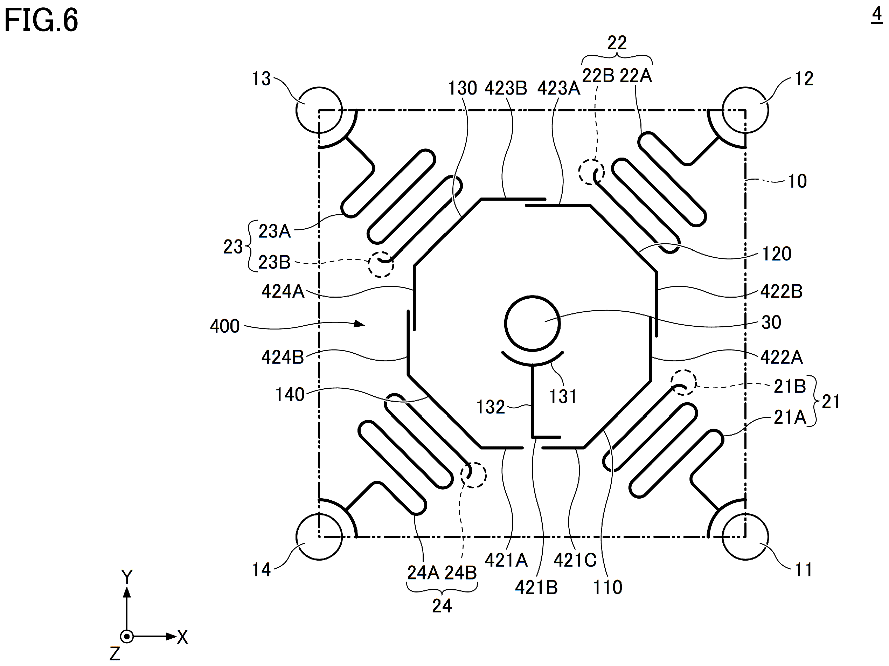

Next, a fourth embodiment will be described. The fourth embodiment differs from the first embodiment mainly in the configuration of the filter. FIG. 6 is a plan view illustrating the quantum device according to the fourth embodiment.

As illustrated in FIG. 6, a quantum device 4 according to the fourth embodiment includes a filter 400 in place of the filter 100. The filter 400 includes transmission lines 421A, 421B, and 421C in place of the transmission line 121, transmission lines 422A and 422B in place of the transmission line 122, transmission lines 423A and 423B in place of the transmission line 123, and transmission lines 424A and 424B in place of the transmission line 124.

The transmission line 421B is connected to the transmission line 132, and extends from the end portion of the transmission line 132 on the -Y side toward the +X side along the X axis. The transmission line 421A is connected to the transmission line 140, and extends from the end portion of the transmission line 140 on the +X side and the -Y side toward the +X side along the X axis. The transmission line 421C is connected to the transmission line 110, and extends from the end portion of the transmission line 110 on the -X side and the -Y side toward the -X side along the X axis. The transmission lines 421A and 421C are separated from the transmission line 421B. The Y coordinates of the transmission lines 421A and 421C are identical. The Y coordinate of the transmission line 421B is larger than the Y coordinates of the transmission lines 421A and 421C. A portion of the transmission line 421B and a portion of the transmission line 421C overlap when viewed from the Y axis direction, and the transmission line 421C and the transmission line 421B are capacitively coupled to each other. A magnitude of the capacitive coupling between the transmission line 421A and the transmission line 421B is smaller than a magnitude of the capacitive coupling between the transmission line 421B and the transmission line 421C. An end portion of the transmission line 421A on the +X side, an end portion of the transmission line 421B on the +X side, and the end portion of the transmission line 421C on the -X side are open-circuited. The transmission lines 421A and 421C are arranged in line symmetry with respect to a straight line passing through the center of the square 10 and parallel to the Y axis.

The transmission line 422A is connected to the transmission line 110, and extends from the end portion of the transmission line 110 on the +X side and the +Y side toward the +Y side along the Y axis. The transmission line 422B is connected to the transmission line 120, and extends from the end portion of the transmission line 120 on the +X side and the -Y side toward the -Y side along the Y axis. The X coordinates of the end portion of the transmission line 110 on the +X side and the +Y side and the transmission line 422A are smaller than the X coordinates of the end portion of the transmission line 120 on the +X side and the -Y side and the transmission line 422B. A portion of the transmission line 422A and a portion of the transmission line 422B overlap when viewed from the X axis direction, and the transmission line 422A and the transmission line 422B are capacitively coupled to each other. An end portion of the transmission line 422A on the +Y side and an end portion of the transmission line 422B on the -Y side are open-circuited.

The transmission line 423A is connected to the transmission line 120, and extends along the X axis from the end portion of the transmission line 120 on the -X side and the +Y side toward the -X side along the X axis. The transmission line 423B is connected to the transmission line 130, and extends from the end portion of the transmission line 130 on the +X side and the +Y side toward the +X side along the X axis. The Y coordinates of the end portion of the transmission line 120 on the -X side and the +Y side and the transmission line 423A are smaller than the Y coordinates of the end portion of the transmission line 130 on the +X side and the +Y side and the transmission line 423B. A portion of the transmission line 423A and a portion of the transmission line 423B overlap when viewed from the Y axis direction, and the transmission line 423A and the transmission line 423B are capacitively coupled to each other. An end portion of the transmission line 423A on the -X side and an end portion of the transmission line 423B on the +X side are open-circuited.

The transmission line 424A is connected to the transmission line 130, and extends from the end portion of the transmission line 130 on the -X side and the -Y side toward the -Y side along the Y axis. The transmission line 424B is connected to the transmission line 140, and extends from the end portion of the transmission line 140 on the -X side and the +Y side toward the +Y side along the Y axis. The X coordinates of the end portion of the transmission line 130 on the -X side and the -Y side and the transmission line 424A are larger than the X coordinates of the end portion of the transmission line 140 on the -X side and the +Y side and the transmission line 424B. A portion of the transmission line 424A and a portion of the transmission line 424B overlap when viewed from the X axis direction, and the transmission line 424A and the transmission line 424B are capacitively coupled to each other. An end portion of the transmission line 424A on the -Y side and an end portion of the transmission line 424B on the +Y side are open-circuited.

A path length of the filter 400 may be approximately 1/2 the wavelength λ or approximately one wavelength λ. For example, at the resonant frequency of 6 GHz of the qubit, the path length is approximately 1/2 the wavelength λ or approximately one wavelength λ in order to prevent propagation of photons emitted from the qubit. On the other hand, this filter does not prevent propagation of a signal having a frequency of 10 GHz at which the resonators 21 through 24 resonate, for example. In addition, the filter 400 may be magnetically coupled to the resonators 21 through 24.

Otherwise, the configuration of the quantum device 4 is the same as that of the quantum device 1. The quantum device 4 according to the fourth embodiment can also provide the same effects as those of the third embodiment.

Further, in the quantum device 4 according to the fourth embodiment, the transmission lines that are capacitively coupled inside the filter 400 have portions overlapping each other when viewed from the X axis direction or the Y axis direction. For this reason, it is easy to control the direction in which a signal is transmitted inside the filter 400.

### (Fifth Embodiment)

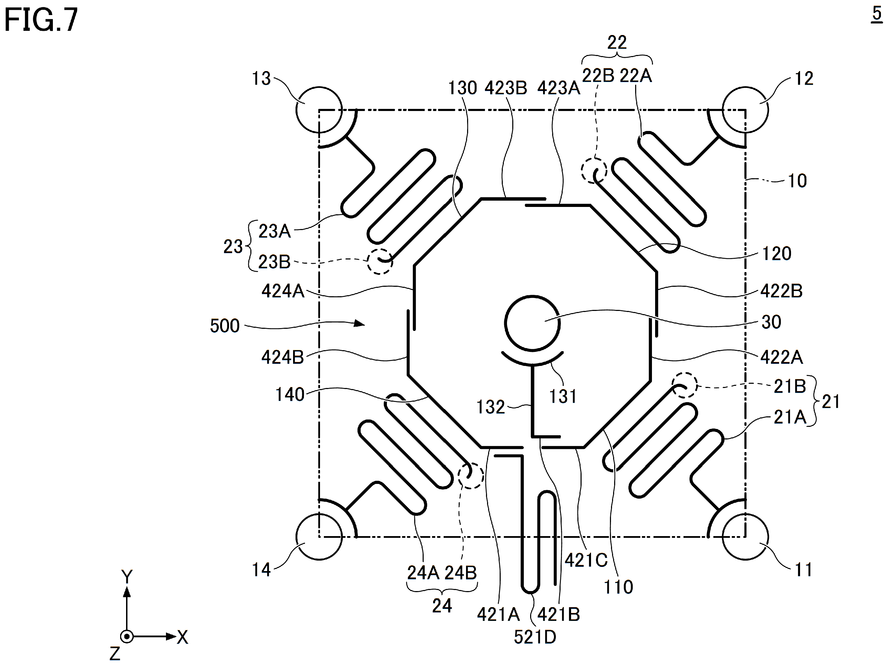

Next, a fifth embodiment will be described. The fifth embodiment differs from the fourth embodiment mainly in the configuration of the filter. FIG. 7 is a plan view illustrating the quantum device according to the fifth embodiment.

As illustrated in FIG. 7, a quantum device 5 according to the fifth embodiment includes a filter 500 in place of the filter 400. The filter 500 differs from the filter 400 in that the path length from the transmission line 131 to the transmission line 421A is shorter than that in the fourth embodiment and the filter 500 further includes a transmission line 521D. The transmission line 521D is capacitively coupled to the transmission line 421A. Both end portions of the transmission line 521D are open-circuited. A path length of the filter 500 may be approximately 1/2 the wavelength λ or approximately one wavelength λ. For example, at the resonant frequency of 6 GHz of the qubit, the path length is approximately 1/2 the wavelength λ or approximately one wavelength λ in order to prevent propagation of photons emitted from the qubit. On the other hand, this filter does not prevent propagation of a signal having a frequency of 10 GHz at which the resonators 21 through 24 resonate, for example.

Otherwise, the configuration of the quantum device 5 is the same as that of the quantum device 4. The quantum device 5 according to the fifth embodiment can also provide the same effects as those of the fourth embodiment.

### (Sixth Embodiment)

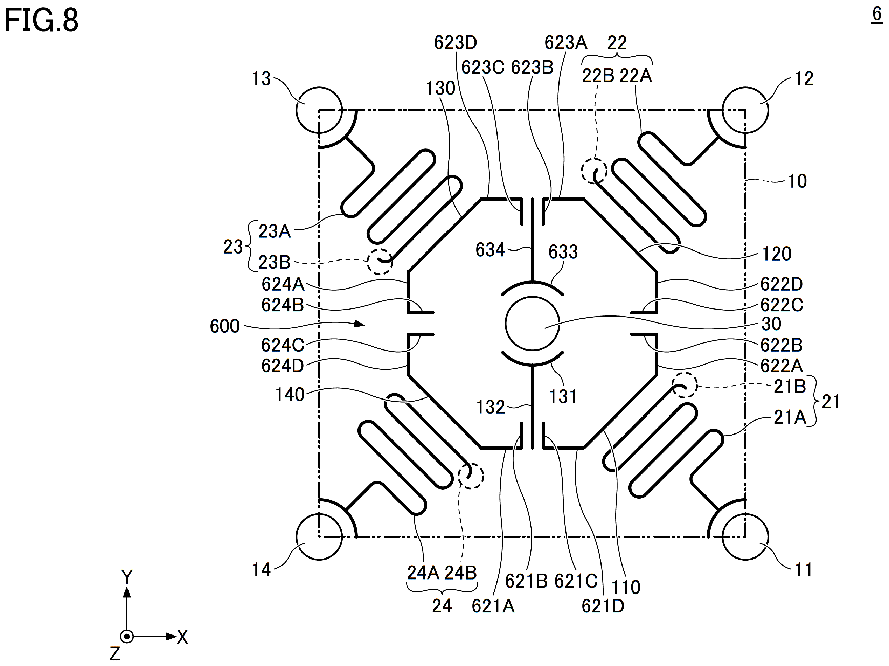

Next, a sixth embodiment will be described. The sixth embodiment differs from the first embodiment mainly in the configuration of the filter. FIG. 8 is a plan view illustrating the quantum device according to the sixth embodiment.

As illustrated in FIG. 8, a quantum device 6 according to the sixth embodiment includes a filter 600 in place of the filter 100. The filter 600 includes transmission lines 621A, 621B, 621C, and 621D in place of the transmission line 621, transmission lines 622A, 622B, 622C, and 622D in place of the transmission line 122, transmission lines 623A, 623B, 623C, and 623D in place of the transmission line 123, and transmission lines 624A, 624B, 624C, and 624D in place of the transmission line 124. The filter 600 further includes transmission lines 633 and 644.

The transmission line 633 is provided near the readout port 30, and has a planar shape along the outer edge of the readout port 30. The planar shape of the transmission line 633 is an arc shape, for example. The transmission line 633 is located on the +Y side of readout port 30. The transmission line 634 is connected to the transmission line 633, and extends from the transmission line 633 toward the +Y side along the Y axis.

The transmission line 621A is connected to the transmission line 140, and extends from the end portion of the transmission line 140 on the +X side and the -Y side toward the +X side along the X axis. The transmission line 621B is connected to the transmission line 621A, and extends from an end portion of the transmission line 621A on the +X-side toward the +Y side along the Y axis. The transmission line 621D is connected to the transmission line 110, and extends from the end portion of the transmission line 110 on the -X side and the -Y side toward the -X side along the X axis. The transmission line 621C is connected to the transmission line 621D, and extends from an end portion of the transmission line 621D on the -X side toward the +Y side along the Y axis. The Y coordinates of the transmission lines 621A and 621D are identical. The X coordinate of the transmission line 621B is smaller than the X coordinate of the transmission line 132. The transmission line 621B and a portion of the transmission line 132 overlap when viewed from the X axis direction, and the transmission line 621B and the transmission line 132 are capacitively coupled to each other. The X coordinate of the transmission line 621C is larger than the X coordinate of the transmission line 132. A portion of the transmission line 621C and a portion of the transmission line 132 overlap when viewed from the X axis direction, and the transmission line 621C and the transmission line 132 are capacitively coupled to each other. An end portion of the transmission line 621B on the +Y side and an end portion of the transmission line 621C on the +Y side are open-circuited. The transmission lines 621A and 621D are arranged in line symmetry with respect to a straight line passing through the center of the square 10 and parallel to the Y axis, and the transmission lines 621B and 621C are arranged in line symmetry with respect to the straight line passing through the center of the square 10 and parallel to the Y axis.

The transmission line 622A is connected to the transmission line 110, and extends from the end portion of the transmission line 110 on the +X side and the +Y side toward the +Y side along the Y axis. The transmission line 622B is connected to the transmission line 622A, and extends from an end portion of the transmission line 622A on the +Y side toward the -X side along the X axis. The transmission line 622D is connected to the transmission line 120, and extends from the end portion of the transmission line 120 on the +X side and the -Y side toward the -Y side along the Y axis. The transmission line 622C is connected to the transmission line 622D, and extends from an end portion of the transmission line 622D on the -Y side toward the -X side along the X axis. The X coordinates of the transmission lines 622A and 622D are identical. The Y coordinate of the transmission line 622B is smaller than the X coordinate of the transmission line 622C. The transmission line 622B and the transmission line 622C overlap when viewed from the Y axis direction, and the transmission line 622B and the transmission line 622C are capacitively coupled to each other. An end portion of the transmission line 622B on the -X side and an end portion of the transmission line 622C on the -X side are open-circuited. The transmission lines 622A and 622D are arranged in line symmetry with respect to a straight line passing through the center of the square 10 and parallel to the X axis, and the transmission lines 622B and 622C are arranged in line symmetry with respect to the straight line passing through the center of the square 10 and parallel to the X axis.

The transmission line 623A is connected to the transmission line 120, and extends from the end portion of the transmission line 120 on the -X side and the +Y side toward the -X side along the X axis. The transmission line 623B is connected to the transmission line 623A, and extends from an end portion of the transmission line 623A on the -X side toward the -Y side along the Y axis. The transmission line 623D is connected to the transmission line 130, and extends from the end portion of the transmission line 130 on the +X side and the +Y side toward the +X side along the X axis. The transmission line 623C is connected to the transmission line 623D, and extends from an end portion of the transmission line 623D on the +X side toward the -Y side along the Y axis. The Y coordinates of the transmission lines 623A and 623D are identical. The X coordinate of the transmission line 623B is larger than the X coordinate of the transmission line 634. A portion of the transmission line 623B and a portion of the transmission line 634 overlap when viewed from the X axis direction, and the transmission line 623B and the transmission line 634 are capacitively coupled to each other. The X coordinate of the transmission line 623C is smaller than the X coordinate of the transmission line 634. A portion of the transmission line 623C and a portion of the transmission line 634 overlap when viewed from the X axis direction, and the transmission line 623C and the transmission line 634 are capacitively coupled to each other. An end portion of the transmission line 623B on the -Y side and an end portion of the transmission line 623C on the -Y side are open-circuited. The transmission lines 623A and 623D are arranged in line symmetry with respect to a straight line passing through the center of the square 10 and parallel to the Y axis, and the transmission lines 623B and 623C are arranged in line symmetry with respect to the straight line passing through the center of the square 10 and parallel to the Y axis.

The transmission line 624A is connected to the transmission line 130, and extends from the end portion of the transmission line 130 on the -X side and the -Y side toward the -Y side along the Y axis. The transmission line 624B is connected to the transmission line 624A, and extends from an end of the transmission line 624A on the -Y side toward the +X side along the X axis. The transmission line 624D is connected to the transmission line 140, and extends from the end portion of the transmission line 140 on the -X side and the +Y side toward the +Y side along the Y axis. The transmission line 624C is connected to the transmission line 624D, and extends from an end portion of the transmission line 624D on the +Y side toward the +X side along the X axis. The X coordinates of the transmission lines 624A and 624D are identical. The Y coordinate of the transmission line 624B is larger than the X coordinate of the transmission line 624C. A portion of the transmission line 624B and a portion of the transmission line 624C overlap when viewed from the Y axis direction, and the transmission line 624B and the transmission line 624C are capacitively coupled to each other. An end portion of the transmission line 624B on the +X side and an end portion of the transmission line 624C on the +X side are open-circuited. The transmission lines 624A and 624D are arranged in line symmetry with respect to a straight line passing through the center of the square 10 and parallel to the X axis, and the transmission lines 624B and 624C are arranged in line symmetry with respect to the straight line passing through the center of the square 10 and parallel to the X axis.

Otherwise, the configuration of the quantum device 6 is the same as that of the quantum device 1. The quantum device 6 according to the sixth embodiment can also provide the same effects as those of the third embodiment. In the quantum device 6, the filter 600 has a higher symmetry in the plan view, and thus, the uniformity of the parasitic capacitances of the resonators 21 through 24 can be improved.

### (Seventh Embodiment)

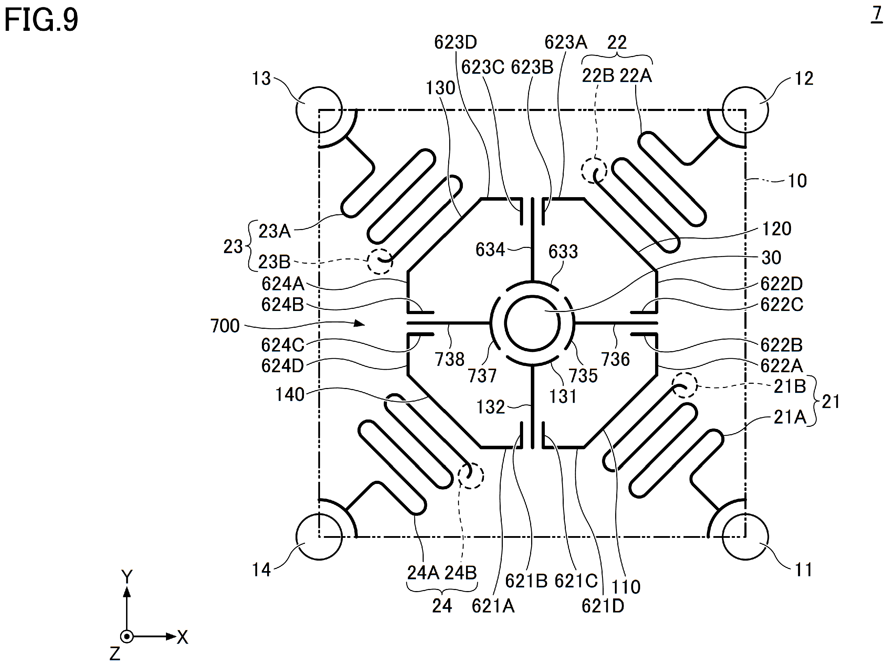

Next, a seventh embodiment will be described. The seventh embodiment differs from the sixth embodiment mainly in the configuration of the filter. FIG. 9 is a plan view illustrating the quantum device according to the seventh embodiment.

As illustrated in FIG. 9, a quantum device 7 according to the seventh embodiment includes a filter 700 in place of the filter 600. The filter 700 differs from the filter 600 in that the filter 700 further includes transmission lines 735, 736, 737, and 738.

The transmission line 735 is provided near the readout port 30, and has a planar shape along the outer edge of the readout port 30. The planar shape of the transmission line 735 is an arc shape, for example. The transmission line 735 is located on the +X side of the readout port 30. The transmission line 736 is connected to the transmission line 735, and extends from the transmission line 735 toward the +X side along the X axis. When viewed from the Y axis direction, portions of the transmission lines 622B and 622C overlap a portion of the transmission line 736, and the transmission lines 622B and 622C are capacitively coupled to the transmission line 736.

The transmission line 737 is provided near the readout port 30, and has a planar shape along the outer edge of the readout port 30. The planar shape of the transmission line 737 is an arc shape, for example. The transmission line 737 is located on the -X side of readout port 30. The transmission line 738 is connected to the transmission line 737, and extends from the transmission line 737 toward the -X side along the X axis. When viewed from the Y axis direction, portions of the transmission lines 624B and 624C overlap a portion of the transmission line 738, and the transmission lines 624B and 624C are capacitively coupled to the transmission line 738.

Otherwise, the configuration of the quantum device 7 is the same as that of the quantum device 6. The quantum device 7 according to the seventh embodiment can also provide the same effects as those of the sixth embodiment. In the quantum device 7, the filter 700 has an even higher symmetry in the plan view, and thus, the uniformity of the parasitic capacitances of the resonators 21 through 24 can further be improved.

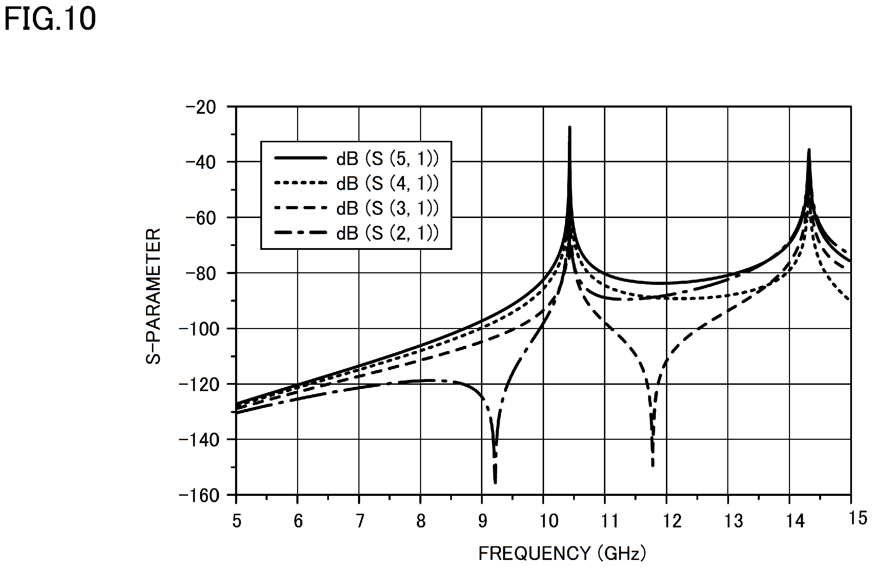

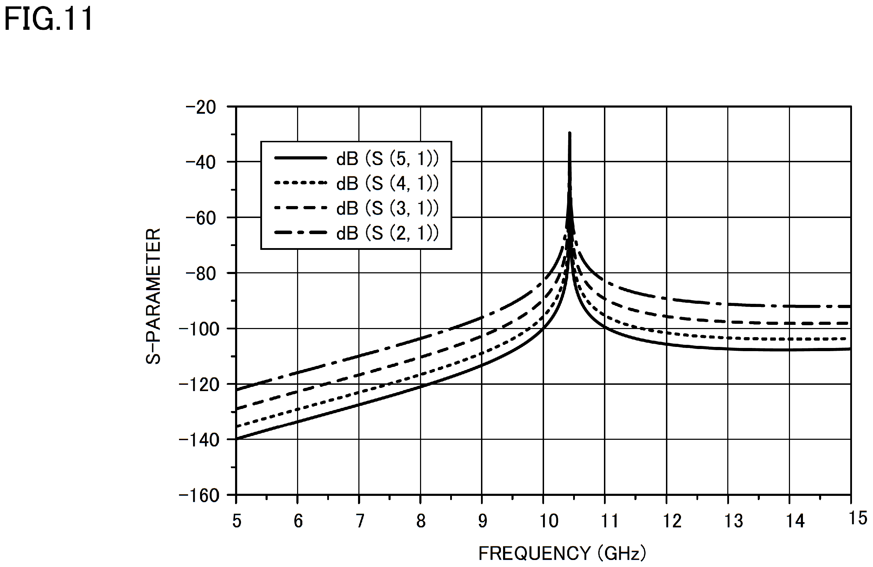

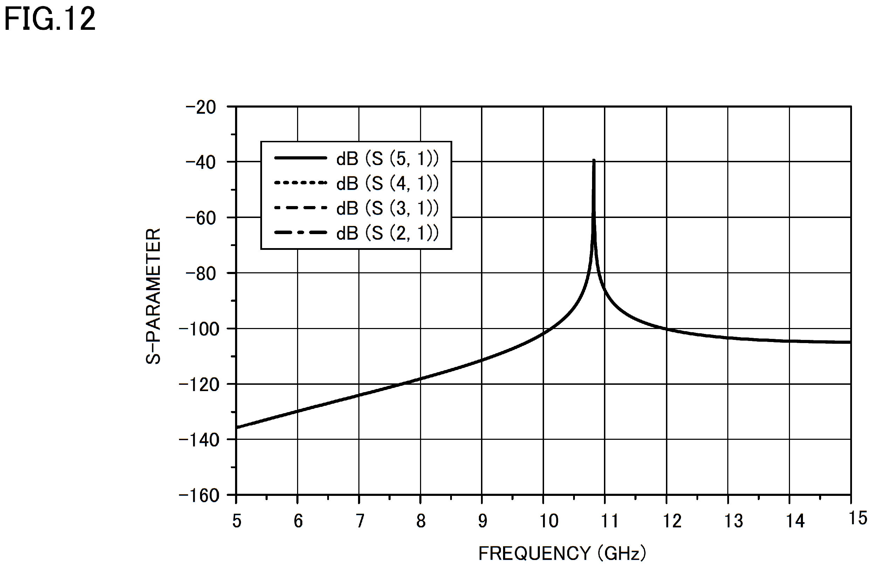

Next, simulations of the quantum devices 1X, 4, and 6 performed by the present inventors will be described. In the simulations, transmission coefficients of superconducting circuits simulating the quantum devices 1X, 4, and 6 were computed as the S-parameters for a case where the readout port 30 is regarded as a first port, the qubit 11 is regarded as a second port, the qubit 12 is regarded as a third port, the qubit 13 is regarded as a fourth port, and the qubit 14 is regarded as a fifth port. In the simulations, the coupling capacitance between the readout port 30 and each filter was set to 5.5 fF, and the coupling capacitance between the transmission lines in the filters 400 and 600 was set to 50 fF. The characteristic impedance of the resonators 21 through 24 was set to 50 Ω, the path length of the resonators 21 through 24 was set to 1/4 the wavelength λ, and the path length of each filter was set to 1/2 the wavelength λ. The coupling capacitance between the qubits 11 through 14 and the corresponding resonators 21 through 24 was set to 1.2 fF. Results of the simulation are illustrated in FIG. 10 through FIG. 12. FIG. 10 is a diagram illustrating the result of the simulation of the quantum device 1X according to the reference example. FIG. 11 is a diagram illustrating the result of the simulation of the quantum device 4 according to the fourth embodiment. FIG. 12 is a diagram illustrating the result of the simulation of the quantum device 6 according to the sixth embodiment. In FIG. 10 through FIG. 12, "dB (S (A, 1))" indicates the transmittance at an A-th port when a signal is input from the first port.

As illustrated in FIG. 10, in the simulation of the quantum device 1X, spurious modes are generated. It may be regarded that the spurious modes are generated because the coupling occurs also between the resonators 21 through 24.

As illustrated in FIG. 11, in the simulation of the quantum device 4, no spurious mode is generated. It may be regarded that no spurious mode is generated because the filter 400 includes a plurality of transmission lines capacitively coupled to each other, thereby improving the isolation between the resonators 21 through 24.

As illustrated in FIG. 12, in the simulation of the quantum device 6, the characteristics at the second port, the third port, the fourth port, and the fifth port are identical. It may be regarded that the characteristics at the second through fifth ports are identical because the symmetry of the filter 600 in the plan view is high and the uniformity of the characteristics of signal transmission among the resonators 21 through 24 is high.

In the computation described above, the eigenmode frequencies of the qubits 11 through 14 are aligned to the eigenmode frequencies of the resonators 21 through 24, respectively, to facilitate understanding of the uniformity of the characteristics obtained as the effects. In actual practice, because the resonator eigenmode frequencies are multiplexed for state readout, the eigenmode frequencies of qubits and resonators may be detuned from one another. In this case, the same effects can be expected.

In the present disclosure, the path length of the filter is not particularly limited. For example, the path length of the filter may be approximately 1/4 the wavelength corresponding to the frequency at which the plurality of resonators resonate, and the filter may be a coplanar waveguide filter. In this case, a tip of the filter is short-circuited to the ground line. That is, the end of the filter opposite to the port side is short-circuited. The filter may be a bandpass filter or a filter that attenuates signals in a specific frequency band. Further, the filter is not limited to the coplanar waveguide filter, and a microstrip waveguide filter or the like may be used for the filter.

Moreover, the number of qubits coupled to one port is not particularly limited. The qubits coupled to one port are preferably located at the vertices of a regular polygon centered at the port.

In the present disclosure, "equal" does not require a perfect match. For example, a manufacturing variation may be included in the term equal. Further, as long as the shortest distances between the bases of the resonators and the ports are equal to one another and the effect of reducing the parasitic capacitance is obtainable, the shortest distances between the resonators and the ports may be slightly different from one another due to the arrangement or the like of the resonant frequency adjusters or the like.

The quantum device according to the present disclosure can be used for quantum computing, for example.

Although the preferred embodiments or the like are described above in detail, the present disclosure is not limited to the embodiments or the like described above, and various modifications and substitutions can be made to the embodiments or the like described above without departing from the scope recited in the claims.

### DESCRIPTION OF THE REFERENCE NUMERALS

1, 2, 3, 4, 5, 6, 7: quantum device
10: square
11, 12, 13, 14: qubit
21, 22, 23, 24: resonator
21A, 22A, 23A, 24A: base
21B, 22B, 23B, 24B: resonant frequency adjuster
100, 200, 300, 400, 500, 600, 700: filter

## Claims

1. A quantum device comprising:
a plurality of superconducting qubits;
a plurality of resonators capacitively coupled to the plurality of superconducting qubits, respectively;
a filter coupled to the plurality of resonators; and
a port capacitively coupled to the filter,
wherein shortest distances between the port and the plurality of resonators are equal among the plurality of resonators.

2. The quantum device as claimed in claim 1, wherein:
a path length of the filter is one wavelength or 1/2 the wavelength corresponding to a frequency at which the plurality of resonators resonate, and
an end of the filter opposite to the port is open-circuited.

3. The quantum device as claimed in claim 2, wherein the filter is a coplanar waveguide filter.

4. The quantum device as claimed in claim 1, wherein:
a path length of the filter is 1/4 a wavelength corresponding to a frequency at which the plurality of resonators resonate, and
an end of the filter opposite to the port is short-circuited.

5. The quantum device as claimed in any one of claims 1 to 4, wherein the filter includes a plurality of transmission lines capacitively coupled to one another.

6. The quantum device as claimed in claim 5, wherein at least some of the plurality of transmission lines are arranged symmetrically between the port and the plurality of resonators.

7. The quantum device as claimed in any one of claims 1 to 4, wherein:
a number of the superconducting qubits and a number of the resonators are three or more, and
in a plan view,
the three or more superconducting qubits are located at vertices of a regular polygon, and
the port is located at a center of the regular polygon.

8. The quantum device as claimed in claim 7, wherein:
each resonator of the three or more resonators includes
a base, and
a resonant frequency adjuster coupled to the base, and
a planar shape of the base is congruent among the three or more resonators.

9. The quantum device as claimed in any one of claims 1 to 4, wherein the filter is capacitively coupled to the plurality of resonators.
